# FASCICULE DE BREVET EUROPEEN

(11) **EP 0 793 344 B1**
(45) Date de publication et mention de la délivrance du brevet: **14.05.2003**
(21) Numéro de dépôt: 97410026.5
(22) Date de dépôt: 25.02.1997
(51) Int. Cl.: H03K 17/725, H01L 29/747

(54) **Interrupteur statique à trois états**
Statischer Schalter mit drei Schaltzuständen
Static switch with three switching states

(30) Priorité: 29.02.1996 FR 9602781
(43) Date de publication de la demande: 03.09.1997
(73) Titulaire: STMicroelectronics S.A., 92120 Montrouge (FR)
(72) Inventeur: Pezzani, Robert, Parçay-Meslay, 37210 Vouvray (FR)
(74) Mandataire: de Beaumont, Michel

(56) Documents cités:
- EP-A- 0 025 291
- DE-A- 2 443 930
- GB-A- 2 237 697
- US-A- 4 049 976

## Description

La présente invention concerne des interrupteurs à trois états destinés à couper ou à laisser passer un courant de sens choisi dans une charge alimentée en alternatif.

Dans certains cas, par exemple quand la charge est un moteur relié à une alimentation alternative, on cherche à prévoir un interrupteur qui, sur commande, permet ou bien de couper le passage du courant dans la charge, ou bien de laisser passer un courant seulement dans un sens donné, ou bien de laisser un courant en sens opposé, de sorte que le moteur soit arrêté ou tourne dans l'une ou l'autre direction.

Dans l'art antérieur, de telles fonctions sont assurées par des circuits interrupteurs et logiques complexes.

La présente invention vise à réaliser cette fonction par un composant monolithique dont le circuit de commande est constitué d'un simple commutateur-sélecteur.

Pour atteindre cet objet, la présente invention prévoit un interrupteur trois états destiné à être inséré dans un circuit d'alimentation alternative associé à un circuit de sélection d'état pour, dans un premier état, être ouvert, dans un deuxième état, autoriser le passage d'un courant d'une première polarité, dans un troisième état, autoriser le passage d'un courant d'une deuxième polarité. Cet interrupteur comprend un thyristor à gâchette de cathode et un thyristor à gâchette d'anode en antiparallèle, la gâchette du thyristor à gâchette de cathode constituant une borne de commande et étant reliée par une résistance à la gâchette du thyristor à gâchette d'anode. Le circuit de sélection d'état comprend un sélecteur dont une première borne est reliée à la borne de commande et dont la deuxième borne est, dans le premier état, connectée directement à la cathode du thyristor à gâchette de cathode, dans le deuxième état, flottante, et dans le troisième état, connectée à un potentiel inférieur d'une valeur déterminée au potentiel de la cathode du thyristor à gâchette de cathode.

Selon un mode de réalisation de la présente invention, dans le troisième état, la deuxième borne du sélecteur est reliée à la cathode du thyristor à gâchette de cathode par l'intermédiaire d'une source de tension d'une valeur de 6 à 20 V.

Selon un mode de réalisation de la présente invention, la résistance a une valeur supérieure à 10 kΩ.

La présente invention prévoit aussi une réalisation monolithique de l'interrupteur trois états susmentionnée dans laquelle les deux thyristors sont des thyristors réalisés verticalement dans un substrat semiconducteur, la face arrière du substrat étant reliée à une métallisation et correspondant à l'anode du thyristor à gâchette de cathode et à la cathode du thyristor à gâchette d'anode, une région diffusée du deuxième type de conductivité à faible niveau de dopage formant une résistance s'étendant à partir de la couche de gâchette de cathode du thyristor à gâchette de cathode vers l'anode du thyristor à gâchette d'anode et une métallisation revêtant l'extrémité de cette résistance à une surface supérieure du substrat.

Selon un mode de réalisation de la présente invention, sous ladite métallisation, sont formées une région du deuxième type de conductivité à niveau de dopage élevé en contact avec l'extrémité de la région à faible niveau de dopage constituant ladite résistance et une région du premier type de conductivité à niveau de dopage élevé en contact avec le substrat.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est un schéma sous forme de blocs illustrant la fonction que la présente invention vise à mettre en oeuvre ;
la figure 2 représente un mode de réalisation de la présente invention ;
la figure 3 est un schéma équivalent destiné à expliquer le fonctionnement d'un interrupteur selon la présente invention dans l'un de ses trois états ; et
la figure 4 représente un exemple de mise en oeuvre d'un interrupteur trois états selon la présente invention sous forme monolithique.

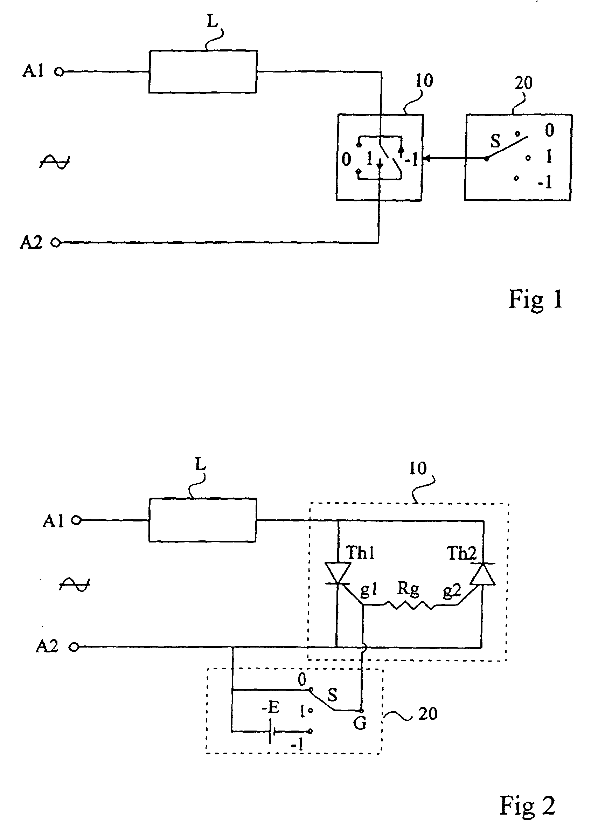

La figure 1 représente une charge L connectée aux bornes A1 et A2 d'un réseau alternatif. Cette charge est disposée en série avec un interrupteur 10 commandé par un circuit de commande ou sélecteur 20. On veut, selon que le sélecteur 20 fournit l'un ou l'autre de trois signaux de commande, désignés de façon logique comme des états 0, 1 et -1, que l'interrupteur 10 soit ou bien ouvert, ou bien laisse passer le courant de la borne A1 vers la borne A2, ou bien laisse passer le courant de la borne A2 vers la borne A1. Ainsi, par exemple, si la charge L est un moteur à courant continu, ceci provoquera l'arrêt du moteur, sa mise en route dans un premier sens de rotation ou sa mise en route dans le deuxième sens de rotation. L'une des deux bornes de l'alimentation alternative, par exemple la borne A2, peut être reliée à la masse.

Comme le représente la figure 2, selon la présente invention, l'interrupteur à trois états 10 est réalisé au moyen de la connexion en antiparallèle d'un thyristor à gâchette de cathode Th1 et d'un thyristor à gâchette d'anode Th2. L'anode du thyristor à gâchette de cathode et la cathode du thyristor à gâchette d'anode sont reliées à la charge L. La cathode du thyristor à gâchette de cathode et l'anode du thyristor à gâchette d'anode sont reliées à la borne A2. La gâchette g1 du thyristor à gâchette de cathode est reliée à la gâchette g2 du thyristor à gâchette d'anode par l'intermédiaire d'une résistance Rg. La gâchette g1 constitue la borne de commande G de l'interrupteur. Cette borne de commande est reliée à une première borne d'un sélecteur S dont la deuxième borne est mobile entre :
- une borne "0" connectée à la cathode du thyristor à gâchette de cathode,
- une borne "1" qui est flottante,
- une borne "-1" reliée à un potentiel plus négatif d'une valeur déterminée que le potentiel de la cathode du thyristor à gâchette de cathode Th1. Ceci peut être réalisé par exemple en disposant une source de tension -E en série entre la borne -1 et la cathode du thyristor Th1. Cette source de tension peut de façon classique être fournie à partir de la tension alternative par un montage classique abaisseur/redresseur.

On va montrer que, selon que le sélecteur S est sur la position 0, 1 ou -1, les deux thyristors Th1 et Th2 sont bloqués, seul le thyristor Th1 est susceptible d'être passant quand la tension sur la borne A1 est supérieure à la tension sur la borne A2, et seul le thyristor Th2 est susceptible d'être passant quand la tension sur la borne A2 est supérieure à la tension sur la borne A1.

Dans l'état 0, le sélecteur S est relié à la borne 0, la borne de commande G est reliée à la cathode du thyristor à gâchette de cathode et à l'anode du thyristor à gâchette d'anode. Le thyristor Th1 ayant sa gâchette reliée à sa cathode est toujours bloqué. Il en est de même pour le thyristor Th2 qui a sa gâchette d'anode reliée à son anode. Aucun courant de gâchette ne peut circuler dans chacun des thyristors Th1, Th2.

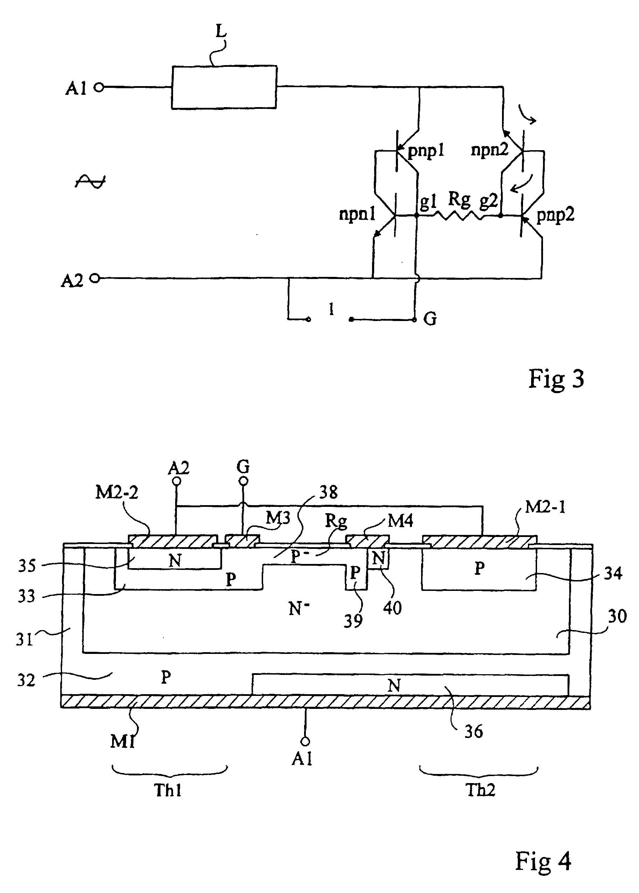

Pour expliquer l'état 1, dans lequel la borne de commande G est maintenue flottante, on se référera au schéma équivalent de la figure 3. Dans cette figure, chacun des thyristors Th1 et Th2 est représenté sous la forme de son schéma équivalent constitué de deux transistors. Le thyristor à gâchette de cathode Th1 équivaut à l'ensemble de deux transistors pnp1 et npn1. L'émetteur du transistor pnp1 correspond à l'anode du thyristor et l'émetteur du transistor npn1 correspond à la cathode du thyristor. La base du transistor pnp1 est connectée au collecteur du transistor npn1. Le collecteur du transistor pnp1 est connecté à la base du transistor npn1, cette connexion correspondant à la gâchette de cathode g1 du thyristor Th1. Le thyristor à gâchette d'anode Th2 équivaut à l'ensemble de deux transistors npn2 et pnp2. L'émetteur du transistor npn2 correspond à la cathode du thyristor Th2 et l'émetteur du transistor pnp2 correspond à l'anode du thyristor Th2. La base du transistor npn2 est connectée au collecteur du transistor pnp2. Le collecteur du transistor npn2 est connecté à la base du transistor pnp2 et cette connexion correspond à la gâchette d'anode g2 du thyristor Th2. La résistance Rg est disposée entre les bornes g1 et g2.

On notera que, dans le cadre d'une réalisation classique de thyristor, la couche centrale des transistors PNP équivalents et la couche de collecteur des transistors NPN équivalents correspondent à une région de type N épaisse et faiblement dopée. Par conséquent, les jonctions des transistors PNP équivalents et la jonction collecteur-base des transistors NPN équivalents ont des tensions de claquage en inverse très élevées, par exemple de l'ordre de 400 volts, c'est-à-dire supérieures à la tension alternative du réseau. Par contre, pour les transistors NPN équivalents, les jonctions émetteur/base sont susceptibles de claquer pour des tensions inverses relativement faibles, de l'ordre d'une dizaine de volts.

Ainsi, à l'état 1, dans lequel la borne de commande G est maintenue flottante, quand la borne A1 est positive par rapport à la borne A2, dès que la différence de potentiel devient suffisante, la jonction émetteur-base du transistor npn2 devient passante en inverse. La jonction collecteur-base du transistor pnp2 est passante en direct. Un courant circule donc de A1 vers A2 à travers la jonction émetteur-base du transistor npn2 en inverse, la jonction collecteur-base du transistor pnp2 en direct, la résistance Rg, et la jonction base-émetteur du transistor npn1 qui est la jonction de gâchette du thyristor Th1. Le thyristor Th1 ayant une tension positive sur son anode et recevant un courant de gâchette de cathode positif devient passant.

Par contre, à l'état 1, quand la borne A2 est positive par rapport à la borne A1, le thyristor Th1 est bloqué puisque polarisé en inverse et le thyristor Th2 ne peut entrer en conduction. En effet, toute circulation de courant de gâchette dans le thyristor Th2 est bloquée par au moins une jonction en inverse à tenue en tension élevée.

Enfin, à l'état -1, dans lequel la borne G est connectée à la cathode du thyristor à gâchette de cathode Th1 et à l'anode du thyristor à gâchette d'anode Th2 par l'intermédiaire d'une source de tension -E, la jonction gâchette-cathode du thyristor Th1 est toujours polarisée en inverse et la jonction gâchette-anode du thyristor Th2 est toujours polarisée en direct. Ainsi, quand la borne A1 est positive par rapport à la borne A2, le thyristor Th1 ne peut être rendu passant tandis que, quand la borne A2 est plus positive que la borne A1, le thyristor Th2 est passant.

Dans cet état -1, quand la borne A1 est positive par rapport à la borne A2, bien que le thyristor Th1 reste bloqué, il apparaît un courant de fuite circulant de A1 vers A2 à travers la jonction émetteur-base du transistor npn2 en inverse, la jonction collecteur-base du transistor pnp2 en direct, la résistance Rg, et la source de tension -E. Pour limiter ce courant, il convient de choisir une valeur élevée pour la résistance Rg, par exemple supérieure à 10 kΩ. Cette valeur de Rg doit être optimisée pour permettre la circulation d'un courant de gâchette d'anode suffisant pour mettre en conduction du thyristor Th2 quand A2 est positif par rapport à A1. Si le thyristor Th2 est un thyristor sensible nécessitant un courant de gâchette supérieur à 200 µA et si E = 12 V, il faut que Rg soit inférieur à 60 kΩ. On pourra par exemple choisir une valeur de 30 kΩ. Avec cette valeur, le courant de fuite susmentionné reste négligeable.

On a donc bien obtenu un interrupteur trois états commandé par des niveaux logiques correspondant à la position d'un sélecteur S pour ou bien bloquer un courant, ou bien en autoriser le passage dans un sens, ou bien en autoriser le passage en sens opposé.

On a décrit précédemment le sélecteur S comme un simple sélecteur manuel. Il sera clair qu'il pourra s'agir d'un dispositif électronique télécommandé ou d'un dispositif électronique utilisant les signaux de commande d'un système électronique de commande tel qu'un microcalculateur.

Selon un avantage de la présente invention, l'interrupteur trois états selon la présente invention peut être réalisé sous forme d'un composant monolithique.

Un exemple de réalisation monolithique d'un tel composant est illustré en figure 4. Dans cette figure, le composant est formé à partir d'une région 30 d'un substrat de type N délimitée par exemple par des murs d'isolement 31 de type P. La face arrière du substrat comporte une couche 32 de type P. La face supérieure du substrat comprend des régions 33 et 34 de type P. A l'intérieur de la région de type P 33 est formée une région de type N 35. Du côté de la face arrière et au moins en regard de la région de type P 34 est formée une région 36 de type N. La face arrière du substrat est revêtue d'une métallisation M1. La région de type P 34 est revêtue d'une métallisation M2-1 et la face supérieure de la région de type N 35 est revêtue d'une métallisation M2-2. Une portion de la région de type P 33 dans laquelle est formée la région 35 est revêtue d'une métallisation M3. Ainsi, les régions PNPN 32-31-33-35 forment le thyristor Th1 dont la région 33 constitue la couche de gâchette de cathode solidaire d'une métallisation M3. Les régions PNPN 34-30-32-36 forment le thyristor à gâchette d'anode Th2. Le substrat 30 correspond à la région de gâchette d'anode du thyristor Th2.

En outre, comme cela est représenté dans la figure 4, la résistance Rg est constituée d'une région 38 de type P faiblement dopée formée du côté de la surface supérieure du substrat. Cette région 38 s'étend à partir d'une partie de la région 33 voisine de la région de gâchette du thyristor Th1 vers la région d'anode 34 du thyristor Th2. Une métallisation M4 établit une liaison entre l'autre extrémité de la région 38 et la région de gâchette d'anode du thyristor Th2. De préférence, la métallisation M4 est formée sur une région 39 surdopée de type P en contact avec la région 38 et sur une région 40 surdopée de type N formées à partir de la face supérieure dans le substrat 30 pour assurer ainsi un contact ohmique entre la deuxième borne de la résistance et la région de gâchette d'anode du thyristor Th2.

En fonctionnement, la métallisation M1 est connectée à la borne A2, la métallisation M2-1/M2-2 est connectée à la borne A1, la métallisation M3 est connectée à la borne G, et la métallisation M4 n'est pas connectée.

## Revendications

1. Interrupteur à trois états destiné à être inséré dans un circuit d'alimentation alternative, l'interrupteur comprenant un circuit de sélection d'état (20) pour :
- dans un premier état (0), être ouvert,
- dans un deuxième état (1), autoriser le passage d'un courant d'une première polarité,
- dans un troisième état (-1), autoriser le passage d'un courant d'une deuxième polarité, et
**caractérisé en ce qu'**il comprend de plus un thyristor à gâchette de cathode (Th1) et un thyristor à gâchette d'anode (Th2) en antiparallèle, la gâchette (g1) du thyristor à gâchette de cathode constituant une borne de commande (G) et étant reliée par une résistance (Rg) à la gâchette (g2) du thyristor à gâchette d'anode, et **en ce que** le circuit de sélection d'état (20) comprend un sélecteur (S) dont une première borne est reliée à la borne de commande (G) et dont la deuxième borne est :
- dans le premier état, connectée directement à la cathode du thyristor à gâchette de cathode,
- dans le deuxième état, flottante,
- dans le troisième état, connectée à un potentiel inférieur d'une valeur déterminée (-E) au potentiel de la cathode du thyristor à gâchette de cathode.

2. Interrupteur à trois états selon la revendication 1, **caractérisé en ce que**, dans le troisième état, la deuxième borne du sélecteur est reliée à la cathode du thyristor à gâchette de cathode par l'intermédiaire d'une source de tension d'une valeur de 6 à 20 volts.

3. Interrupteur à trois états selon la revendication 2, **caractérisé en ce que** ladite résistance (Rg) a une valeur supérieure à 10 kΩ.

4. Interrupteur à trois états selon la revendication 1, **caractérisé en ce que** l'interrupteur est réalisé de façon monolithique et **en ce que** les deux thyristors sont des thyristors réalisés verticalement dans un substrat semiconducteur (30), la face arrière du substrat étant reliée à une métallisation première (M1) et correspondant à l'anode du thyristor à gâchette de cathode et à la cathode du thyristor à gâchette d'anode, une région diffusée du deuxième type de conductivité à faible niveau de dopage (38) formant une résistance (Rg) s'étendant à partir de la couche de gâchette de cathode (33) du thyristor à gâchette de cathode vers l'anode du thyristor à gâchette d'anode et une deuxième métallisation (M4) revêtant l'extrémité de cette résistance à une surface supérieure du substrat.

5. Interrupteur à trois états selon la revendication 4, **caractérisé en ce que**, sous la deuxième métallisation (M4), sont formées une région (39) du deuxième type de conductivité à niveau de dopage élevé en contact avec l'extrémité de la région à faible niveau de dopage constituant ladite résistance et une région (40) du premier type de conductivité à niveau de dopage élevé en contact avec le substrat.

## Patentansprüche

1. Scbalter mit drei Zuständen, zur Einfügung in eine Wechselstrom-Speiseschaltung, wobei der Schalter eine Zustands-Wählschaltung (20) umfaßt, mit der Wirkung, daß er
- in einem ersten Zustand (0) geöffnet ist,
- in einem zweiten Zustand (1) einen Stromdurchgang einer ersten Polarität gestattet,
- in einem dritten Zustand (-1) einen Stromdurchgang in einer zweiten Polarität gestattet,
**dadurch gekennzeichnet, daß** der Schalter des weiteren einen Thyristor mit Kathodengate (Th1) und einen Thyristor mit Anodengate (Th2) in Antiparallel-Anordnung aufweist, daß das Gate (g1) des Kathodengate-Thyristors einen Steueranschluß (G) bildet und über einen Widerstand (Rg) mit dem Gate (g2) des Anodengate-Thyristors verbunden ist, und daß die Zustands-Wählschaltung (20) einen Wählschalter bzw. Selektor (S) umfaßt, von dem ein erster Kontakt mit dem Steueranschluß (G) verbunden ist und dessen zweiter Kontaktanschluß:
- in dem ersten Zustand direkt mit der Kathode des Katbodengate-Thyristors verbunden ist,
- in dem zweiten Zustand irei-flottierend ist, und
- in dem dritten Zustand mit einem Potential verbunden ist, das um einen bestimmten Betrag niedriger als das Potential der Kathode des Thyristors mit Gate-Kathode ist.

2. Dreizustandsschalter nach Anspruch 1, **dadurch gekennzeichnet, daß** in dem dritten Zustand der zweite Selektoranschluß mit der Kathode des Kathoden-Gate-Transistors über eine Spannungsquelle mit einem Betrag von 6 bis 20 V verbunden ist.

3. Dreizustands-Schalter nach Anspruch 2, **dadurch gekennzeichnet, daß** der genannte Widerstand (Rg) einen Betrag von mehr als 10 k-Ohm besitzt.

4. Dreizustandsschalter nach Anspruch 1, **dadurch gekennzeichnet, daß** der Schalter in monolithischer Bauweise ausgebildet ist und daß die beiden Thyristoren vertikal in einem Halbleitersubstrat (30) ausgebildete Thyristoren sind, daß die Rückseite des Substrats mit einer ersten Metallisierung (M1) verbunden ist und der Anode des Kathodengate-Thyristors sowie der Kathode des Anodengate-Thyristors entspricht, und daß ein Diffusionsbereich vom zweiten Leitfahigkeitstyp mit schwachem Dotierungsgrad (38) einen Widerstand (Rg) bildet, der sich von der Kathodengate-Schicht (33) des Kathodengate-Transistors zur Anode des Anodengate-Transistors und einer zweiten Metallisierung (M4) erstreckt, welche das Ende dieses Widerstands an einer Oberseitenoberfläche des Substrats überdeckt.

5. Dreizustands-Schalter nach Anspruch 4, **dadurch gekennzeichnet, daß** unter der zweiten Metallisierung (M4) ein Bereich (39) des zweiten Leitfähigkeitstyps von hohem Dotierungspegel in Kontakt mit dem Ende des den genannten Widerstand bildenden Bereichs mit niedrigem Dotierungspegel sowie ein Bereich (40) des ersten Leitfähigkeitstyps mit hohem Dotierungspegel in Kontakt mit dem Substrat ausgebildet sind.

## Claims

1. A three-state switch designed to be inserted in an ac supply circuit, the switch comprising a state selection circuit (20) to:
- in a first state (0), be open,
- in a second state (1), allow a current of a first polarity to flow,
- in a third state (-1), allow a current of a second polarity to flow, and
**characterized in that** the switch further includes a cathode gate thyristor (Th1) and an anode gate thyristor (Th2) connected head-to-tail, the gate (g1) of the cathode gate thyristor forming a control terminal (G) and being connected through a resistor (Rg) to the gate (g2) of the anode gate thyristor, and **in that** the state selection circuit (20) includes a selector (S) having a first terminal connected to the control terminal (G) and a second terminal which:
- in the first state, is directly connected to the cathode of the cathode gate thyristor,
- in the second state, is floating, and
- in the third state, is connected to a voltage lower by a predetermined value (-E) than the cathode voltage of the cathode gate thyristor.

2. The three-state switch according to claim 1, **characterized in that**, in the third state, the second terminal of the selector is connected to the cathode of the cathode gate thyristor through a voltage source having a value ranging between 6 to 20 volts.

3. The three-state switch according to claim 2, **characterized in that** the resistor (Rg) has a value higher than 10 kΩ.

4. The three-state switch according to claim 1, **characterized in that** it is implemented monolithically and the two thyristors are vertical thyristors in a semiconductor substrate (30), the bottom surface of the substrate being connected to a first metallization (M1) and corresponding to the anode of the cathode gate thyristor and to the cathode of the anode gate thyristor, a diffused low doping level region (38) of the second conductivity type forming a resistor (Rg) extending from the cathode gate layer (33) of the cathode gate thyristor towards the anode of the anode gate thyristor and a second metallization (M4) coating the end of the resistor at an upper surface of the substrate.

5. The three-state switch according to claim 4, **characterized in that**, beneath the second metallization (M4), are formed a region (39) of the second conductivity type with a high doping level in contact with the low doping level region which forms the resistor and a region (40) of the first conductivity type with a high doping level in contact with the substrate.
